# EUROPEAN PATENT SPECIFICATION

(11) **EP 2 022 871 B1**
(45) Date of publication and mention of the grant of the patent: **22.08.2012**
(21) Application number: 08104904.1
(22) Date of filing: 29.07.2004
(51) Int. Cl.: C23C 14/08, C23C 14/34, G11B 7/24, G11B 7/26

(54) **Optical information recording medium and process for producing the same**
Optisches Informationsaufzeichnungsmaterial und Herstellungsverfahren dafür
Moyen d'enregistrement d'information optique et processus de fabrication de semblable

(30) Priority: 17.02.2004 JP 2004039139
(43) Date of publication of application: 11.02.2009
(62) Divisional of application: 04771017.3
(73) Proprietor: JX Nippon Mining & Metals Corporation, Tokyo 100-8164 (JP)
(72) Inventor: Takami, Hideo Nippon Mining & Metals Co. Ltd., Kitaibaraki-shi Ibaraki 3191535 (JP); Yahagi, Masataka Nippon Mining & Metals Co. Ltd., Kitaibaraki-shi Ibaraki 3191535 (JP)
(74) Representative: Hoarton, Lloyd Douglas Charles

(56) References cited:
- EP-A- 1 211 679
- US-A1- 2003 148 871
- US-A1- 2004 027 982

## Description

### TECHNICAL FIELD

The present invention relates to a thin film for an optical information recording medium (especially used as a protective film) that has stable film amorphous nature, realizes high deposition speed, is superior in adhesiveness and mechanical properties with the recording layer, has a high transmission factor, and is composed with a non-sulfide system, whereby the deterioration of the adjacent reflective layer and recording layer can be suppressed. The present invention also relates to a manufacturing method of such a thin film, and a sputtering target for use therein.

### BACKGROUND

Conventionally, ZnS-SiO₂ generally and primarily used as a protective layer of a phase change optical information recording medium has superior characteristics such as in optical characteristics, heat characteristics, and adhesiveness with the recording layer, and is being widely used.

Nevertheless, rewritable DVDs in the present day as represented by Blue-Ray disks are strongly demanded of more write cycles, greater capacity, and faster recording.

As one reason for deterioration in the write cycles of an optical information recording medium, there is the diffusion of a sulfur constituent from the ZnS-SiO₂ to the recording layer material disposed in between the protective layers formed from ZnS-SiO₂.

Further, although pure Ag or Ag alloy having high thermal conduction properties with a high reflection ratio is being used as the reflective layer material for realizing high capacity and high-speed recording, this kind of reflective layer is also disposed to come in contact with the protective layer material of ZnS-SiO₂.

Therefore, in this case also, as a result of diffusion of the sulfur constituent from the ZnS-SiO₂, the pure Ag or Ag alloy reflective layer material is subject to corrosive degradation, and would cause the characteristic degradation in the reflection ratio of the optical information recording medium.

As a measure for preventing the diffusion of such sulfur constituent, attempts have been made to provide an intermediate layer having nitrides or carbides as its primary component between the reflective layer and protective layer, and between the recording layer and protective layer. Nevertheless, this results in an increased number of layers, and there is a problem in that throughput will deteriorate and costs will increase.

In order to overcome the foregoing problems, there is a pressing need to substitute the material with an oxide material that does not contain sulfides in the protective layer material, or discover a material having optical characteristics and amorphous stability that are equivalent to or better than ZnS-SiO₂.

Further, since a ceramic target of ZnS-SiO₂ or the like has high bulk electric resistance, it is not possible to perform deposition with a DC sputtering device, and a radio frequency sputtering (RF) device is generally used.

In reality, not only is this radio frequency sputtering (RF) device an expensive device, it has numerous drawbacks in that the sputtering efficiency is inferior, power consumption is significant, control is difficult, and deposition speed is slow.

Moreover, when high power is applied to increase the deposition speed, there is a problem in that the substrate temperature will rise, and a polycarbonate substrate would deform.

In light of the above, a transparent conductive material that does not use ZnS; in other words, that does not contain a sulfur constituent has been proposed (refer to Patent Document 1 and Patent Document 2).

Nevertheless, Patent Document 1 has a problem in that it contains areas where the optical characteristics and amorphous nature are inferior, and Patent Document 2 has a problem in that it contains areas where sufficient deposition speed cannot be obtained, and where the amorphous nature is inferior.
[Patent Document 1] Japanese Patent Laid-Open Publication No. 2000-256059
[Patent Document 2] Japanese Patent Laid-Open Publication No. 2000-256061

EP 1 211 679 A shows an optically transparent film made by sputtering a target containing a glass forming oxide selected from a list including SiO₂ in addition to Al₂O₃ or Ga₂O₃, the balance being one or more of the oxides of indium, tin or zinc.

### SUMMARY

An object of the present invention is to provide a thin film for an optical information recording medium (especially used as a protective film) that has stable film amorphous nature, realizes high deposition speed, is superior in adhesiveness and mechanical properties with the recording layer, has a high transmission factor, and is composed with a non-sulfide system, whereby the deterioration of the adjacent reflective layer and recording layer can be suppressed. The present invention also provides a manufacturing method of such a thin film, and a sputtering target for use therein. As a result, the present invention is able to improve the performance of the optical information recording medium, and to considerably improve the productivity thereof.

In order to overcome the foregoing problems, as a result of intense study, the present inventors discovered that, by substituting the conventional protective layer material ZnS-SiO₂ with an oxide material presented below that does not contain sulfides, it is possible to ensure optical characteristics and amorphous stability that are equivalent to ZnS-SiO₂, and it is further possible to realize high-speed deposition while improving the characteristics of the optical information recording medium and improving the productivity.

Based on the foregoing discovery, the present invention provides a thin film and method according to the appended claims.

### Effect of the Invention

As a result of the above, by substituting the protective layer material ZnS-SiO₂ with an oxide material that does not contain sulfides, it is possible to provide to a thin film for an optical information recording medium (especially used as a protective film) that has superior characteristics such as having stable film amorphous nature, realizing high deposition speed, being superior in adhesiveness and mechanical properties with the recording layer, and having a high transmission factor, whereby the deterioration of the adjacent reflective layer and recording layer caused by sulfur can be suppressed, as well as a manufacturing method of such a thin film, and a sputtering target for use therein.

Further, by using this material, a superior effect is yielded in that it is possible to improve the performance of the optical information recording medium, and considerably improve the productivity thereof.

### BEST MODE FOR CARRYING OUT THE INVENTION

A sputtering target is formed from a material obtained by adding any one or both of SiO₂ and B₂O₃ oxides to an In₂O₃-ZnO-SnO₂ system compound oxide having SnO₂ as its primary component.

It has been discovered that this material has stable optical characteristics and amorphous nature of the film, is suitable as a protective layer material of a phase change optical recording medium, and the sputtering deposition speed via radio frequency sputtering is also high.

As a result of further adding an adequate amount of SiO₂, B₂O₃ to this material, the amorphous nature can be stabilized and the transmission factor can be improved even further, and, therefore, this is suitable as a protective layer material for a phase change recording medium or a blue laser phase change recording medium with a fast rewriting speed.

Further, in particular, when adding SiO₂, it is desirable that the sputtering target is formed from oxide composed with the respective element ratios being In/(In + Zn + Sn + Si) = 0.01 to 0.43, Zn/(In + Zn + Sn + Si) = 0.02 to 0.47, Sn/(In + Zn + Sn + Si) = 0.19 to 0.82, Si/(ln + Zn + Sn + Si) = 0.04 to 0.50, and preferably (Sn + Si)/(ln + Zn + Sn + Si) = 0.45 to 0.90.

As a result, it is possible to improve the amorphous stability and optical characteristics (refractive index and transmission factor): When deviating from the foregoing numerical range, the foregoing characteristics tend to become inferior.

Moreover, when adding B₂O₃, it is desirable that the sputtering target is formed from oxide composed with the respective element ratios being In/(ln + Zn + Sn + B) = 0.01 to 0.41, Zn/(In + Zn + Sn + B) = 0.02 to 0.45, Sn/(ln + Zn + Sn + B) = 0.13 to 0.81, B/(In + Zn + Sn + B) = 0.09 to 0.66, and preferably (Sn + B)/(ln + Zn + Sn + B) = 0.45 to 0.90. As a result, it is possible to further improve the amorphous stability and optical characteristics (refractive index and transmission factor)

Further, the sputtering target is able to achieve a relative density of 90% or higher. The improvement in density yields an effect of improving the uniformity of the sputtered film and inhibiting the generation of particles during sputtering.

The sputtering target described above can be used to form a thin film in a part of an optical information recording medium structure to provide an optical information recording medium. Further, the foregoing sputtering target can be used to form a thin film in a part of an optical information recording medium structure, and the thin film is disposed adjacent to a recording layer or a reflective layer.

As a result of forming a material having as its primary component SnO₂ composed from the oxides of In₂O₃ and ZnO and SnO₂, a certain degree of conductivity can be retained, and, as a result, it is possible to increase deposition speed via radio frequency sputtering.

Further, since it will be possible to thinly form the film thickness of the protective film itself by adjusting the optical characteristics, it will be possible to exhibit further effects of improving the productivity and preventing the heating of the substrate.

Moreover, the thin film formed using the sputtering target forms a part of the optical information recording medium structure and is disposed adjacent to the recording layer or reflective layer, but as described above, ZnS is not used, there is no contamination by S, there is no diffusion of the sulfur constituent to the recording layer material disposed between the protective layers, and there is a significant effect in that the deterioration of the recording layer can be prevented thereby.

Further, when using pure Ag or Ag alloy having high thermal conduction properties and a high reflection ratio as material of adjacent reflective layers for realizing high capacity and high-speed recording, diffusion of the sulfur constituent to such adjacent reflective layers will not occur, and a superior effect is yielded in that the cause of the reflective layer material being subject to corrosive degradation and causing characteristic degradation in the reflection ratio of the optical information recording medium can be cleared out.

The sputtering target can be manufactured by subjecting the oxide powder of the respective constituent elements, in which the average grain size is 5 µm or less, to pressureless sintering or high temperature pressure sintering. It is thereby possible to obtain a sputtering target having a relative density of 90% or higher. In such a case, it is desirable to calcinate the oxide powder having tin oxide as its primary component at a temperature of 800 to 1300°C before sintering. After this calcination, the resultant powder is pulverized to 3 *µ*m or less and used as the raw material for sintering.

Further, by using the sputtering target , a significant effect is yielded in that it is possible to improve the productivity, obtain a high-quality material, and stably manufacture an optical recording medium having an optical disk protective film at low costs.

Improvement in the density of the sputtering target reduces holes and miniaturizes crystal grains, and enables the sputtered face of the target to become uniform and smooth. As a result, a significant result is yielded in that particles and nodules generated during sputtering can be reduced, the target life can be extended, and the mass productivity can be improved with minimal variation in the quality.

### Examples

Examples and Comparative Examples ofsputtering targets are now explained. These Examples are merely illustrative, and the present invention shall in no way be limited thereby. In other words, the present invention shall only be limited by the scope of the present invention, and shall include the various modifications other than the Examples of this invention.

### (Examples 1 to 3)

ln₂O₃ powder, ZnO powder, SiO₂ powder equivalent of 4N and 5*µ*m or less and SnO₂ powder equivalent of 4N and an average grain size of 5*µ*m or less were prepared, and these powders were mixed to achieve the composition shown in Table 1, subject to wet blending, dried, and thereafter calcinated at 1100°C.

Further, after subjecting the calcinated powder to wet pulverization up to an average grain size equivalent to 1 µm, a binder was added and this was granulated with a spray dryer. This granulated powder was subject to cold pressure forming, thereafter subject to pressureless sintering under oxygen atmosphere at 1200°C, and this sintered material was formed into a target with machining process. The constituent and composition ratio (In/(In + Zn + Sn + Si), Zn/(In + Zn + Sn + Si), Sn/(ln + Zn + Sn + Si), Si/(In + Zn + Sn + Si)) of this target are shown in Table 1.

**[Table 1]**

| Examples | Constituent | Composition | Transmission Factor 633nm (%) | Refractive Index 633nm | Amorphous Nature | Sputtering Method | Deposition Speed (Å/sec) nm/sec |
|---|---|---|---|---|---|---|---|
| | | In/(In + Zn + Sn + Si) | | | | | |
| | | Zn/(In + Zn + Sn + Si) | | | | | |
| | | Sn/(In + Zn + Sn + Si) | | | | | |
| | | Si/(In + Zn + Sn + Si) | | | | | |
| Example 1 | In₂O₃ | 0.18 | 95 | 2.2 | 1.2 | RF | (3.2) 0.32 |
| | ZnO | 0.18 | | | | | |
| | SnO₂ | 0.53 | | | | | |
| | SiO₂ | 0.11 | | | | | |
| Example 2 | In₂O₃ | 0.05 | 98 | 1.9 | 1.0 | RF | (1.5) 0.15 |
| | ZnO | 0.10 | | | | | |
| | SnO₂ | 0.51 | | | | | |
| | SiO₂ | 0.34 | | | | | |
| Example 3 | In₂O₃ | 0.12 | 92 | 2.2 | 1.2 | RF | (2.1) 0.21 |
| | ZnO | 0.36 | | | | | |
| | SnO₂ | 0.42 | | | | | |
| | SiO₂ | 0.10 | | | | | |
| Comparative Example 1 | In₂O₃ | 0.03 | 84 | 2.3 | 3.4 | DC | (5.2) 0.52 |
| | ZnO | 0.08 | | | | | |
| | SnO₂ | 0.86 | | | | | |
| | SiO₂ | 0.03 | | | | | |
| Comparative Example 2 | In₂O₃ | 0.008 | 98 | 1.7 | 1.1 | RF | (0.3) 0.03 |
| | ZnO | 0.052 | | | | | |
| | SnO₂ | 0.25 | | | | | |
| | SiO₂ | 0.69 | | | | | |
| Comparative Example 3 | In₂O₃ | 0.53 | 91 | 1.9 | 4.2 | DC | (4.1) 0.41 |
| | ZnO | 0.13 | | | | | |
| | SnO₂ | 0.27 | | | | | |
| | SiO₂ | 0.07 | | | | | |
| Comparative Example 4 | ZnS | 20mol% SiO₂ | 98 | 2.1 | 1.1 | RF | (3.7) 0.36 |
| | SiO₂ | | | | | | |

Amorphous nature was represented with the maximum peak strength against an undeposited glass substrate in a range of 2θ = 20-60° in the XRD measurement of the deposition sample subject to anneal processing (600°C x 30min, Ar atmosphere).

The foregoing 6-inch Øsize target subject to finish processing was used to perform sputtering. The sputtering conditions were RF sputtering, sputtering power of 1000W, and Ar gas pressure of 0.5Pa, and deposition was performed at a target film thickness of 150nm (1500Å).

Results of the measured transmission factor (wavelength 633nm)%, refractive index (wavelength 633nm), amorphous nature (represented with the maximum peak strength against an undeposited glass substrate in a range of 2 = 20-60° in the XRD measurement (Cu-Kα, 40kV, 30mA) of the deposition sample subject to anneal processing (600°C x 30min, Ar atmosphere), as well as the sputtering method and deposition speed (/sec) of the deposition sample are collectively shown in Table 1.

As a result of the above, the sputtering target of Examples 1 to 3 achieved a relative density of 90 to 99%, and stable RF sputtering could be performed. In addition, the deposition speed achieved 0.15 to 0.32nm/sec (1.5 to 3.2Å/sec), and showed extremely favorable sputtering performance.

The transmission factor of the sputtered film achieved 92 to 98% (633nm), the refractive index was 1.9 to 2.2, no specific crystal peak could be observed, and possessed a stable amorphous nature (1.0 to 1.2).

Since the targets of the Examples do not use ZnS, there is no characteristic degradation in the optical information recording medium caused by the diffusion or contamination of sulfur. Further, in comparison to the Comparative Examples described later, the transmission factor, refractive index, amorphous stability, target density, and deposition speed of the deposition sample all showed favorable numerical values.

### (Comparative Example 1 to 3)

As shown in Table 1, materials having components and compositions of raw material powder that are different from the conditions described herein were prepared, and, particularly in Comparative Example 4, ZnS raw material powder was prepared, and targets were prepared with these materials under the same conditions as the Examples, and such targets were used to form a sputtered film. For certain materials, DC (direct current) sputtering was implemented.

The results are similarly shown in Table 1.

With respect to the components and compositions of the Comparative Examples that deviate from the composition ratio described herein; for instance regarding Comparative Example 1, although the deposition speed was fast since the Sn oxide content was high and the Si oxide content was low, the transmission factor was 84%, the refractive index was 2.3 and the amorphous nature was 3.4 and showed inferior results.

With Comparative Example 2, since the In oxide content was low and the Si oxide content was high, the deposition speed was 0.03nm/sec (0.3Å/sec) even with radio frequency sputtering and showed significantly inferior results.

With Comparative Example 3, since the In oxide content was high, the amorphous nature was inferior at 4.2.

Further, Comparative Example 4 in particular contained large amounts of ZnS, and resulted in a material with risk of being contamination with sulfur.

### (Examples 4 to 6)

In₂O₃ powder, ZnO powder, B₂O₃ powder equivalent of 4N and 5µm or less and SnO₂ powder equivalent of 4N and an average grain size of 5µm or less were prepared, and these powders were mixed to achieve the composition shown in Table 2, subject to wet blending, dried, and thereafter calcinated at 1100°C.

Further, this calcinated powder was used to form a target as with Examples 1 to 3. The constituent and composition ratio (In/(In + Zn + Sn + B), Zn/(In + Zn + Sn + B), Sn/(In + Zn + Sn + B), B/(In + Zn + Sn + B)) of this target are shown in Table 2.

**[Table 2]**

| Examples | Constituent | Composition | Transmission Factor 633nm (%) | Refractive Index 633nm | Amorphous Nature | Sputtering Method | Deposition Speed (Å/sec) nm/sec |
|---|---|---|---|---|---|---|---|
| | | In/(In + Zn + Sn + B) | | | | | |
| | | Zn/(In + Zn + Sn + B) | | | | | |
| | | Sn/(In + Zn + Sn + B) | | | | | |
| | | B/(In + Zn + Sn + B) | | | | | |
| Example 4 | In₂O₃ | 0.16 | 94 | 2.1 | 1.2 | RF | (1.9) 0.19 |
| | ZnO | 0.16 | | | | | |
| | SnO₂ | 0.48 | | | | | |
| | B₂O₃ | 0.20 | | | | | |
| Example 5 | In₂O₃ | 0.10 | 98 | 1.9 | 1.0 | RF | (0.8) 0.08 |
| | ZnO | 0.10 | | | | | |
| | SnO₂ | 0.30 | | | | | |
| | B₂O₃ | 0.50 | | | | | |
| Example 6 | in₂O₃ | 0.11 | 93 | 2.1 | 1.2 | RF | (1.8) 0.18 |
| | ZnO | 0.33 | | | | | |
| | SnO₂ | 0.39 | | | | | |
| | B₂O₃ | 0.17 | | | | | |
| Comparative Example 5 | In₂O₃ | 0.19 | 84 | 2.3 | 3.4 | DC | (5.2) 0.52 |
| | ZnO | 0.19 | | | | | |
| | SnO₂ | 0.56 | | | | | |
| | B₂O₃ | 0.06 | | | | | |
| Comparative Example 6 | In₂O₃ | 0.08 | 97 | 1.7 | 1.1 | RF | (0.4) 0.04 |
| | ZnO | 0.08 | | | | | |
| | SnO₂ | 0.12 | | | | | |
| | B₂O₃ | 0.72 | | | | | |
| Comparative Example 7 | In₂O₃ | 0.10 | 83 | 2.4 | 3.1 | DC | (5.5) 0.55 |
| | ZnO | 0.01 | | | | | |
| | SnO₂ | 0.82 | | | | | |
| | B₂O₃ | 0.07 | | | | | |

Amorphous nature was represented with the maximum peak strength against an undeposited glass substrate in a range of 2θ = 20-60° In the XRD measurement of the deposition sample subject to anneal processing (600°C x 30min, Ar atmosphere).

The foregoing 6-inch Øsize target subject to finish processing was used to perform sputtering. The sputtering conditions were RF sputtering, sputtering power of 1000W, and Ar gas pressure of 0.5Pa, and deposition was performed at a target film thickness of 150nm (1500Å).

Results of the measured transmission factor (wavelength 633nm)%, refractive index (wavelength 633nm), amorphous nature (represented with the maximum peak strength against an undeposited glass substrate in a range of 2 = 20-60° in the XRD measurement (Cu-Kα, 40kV, 30mA) of the deposition sample subject to anneal processing (600°C X 30min, Ar atmosphere), as well as the sputtering method and deposition speed in nm/sec (Å/sec) of the deposition sample are collectively shown in Table 2.

As a result of the above, the sputtering target of Examples 4 to 6 achieved a relative density of 90 to 95%, and stable RF sputtering could be performed. In addition, the deposition speed achieved 0.08 to 0.19nm/sec (0.8 to 1.9Å/sec), and showed favorable and stable sputtering performance.

The transmission factor of the sputtered film achieved 93 to 98% (633nm), the refractive index was 1.9 to 2.1, no specific crystal peak could be observed, and possessed a stable amorphous nature (1.0 to 1.2).

Since the targets of the Examples do not use ZnS, there is no characteristic degradation in the optical information recording medium caused by the diffusion or contamination of sulfur. Further, in comparison to the Comparative Examples described later, the transmission factor, refractive index, amorphous stability, target density, and deposition speed of the deposition sample all showed favorable numerical values.

### (Comparative Examples 5 to 7)

As shown in Table 2, materials having components and compositions of raw material powder that are different from the conditions described herein were prepared, and targets were prepared with these materials under the same conditions as the Examples, and such targets were used to form a sputtered film. For certain materials, DC (direct current) sputtering was implemented. The results are similarly shown in Table 1.

With respect to the components and compositions of the Comparative Examples that deviate from the composition ratio described herein; for instance regarding Comparative Example 5, although the deposition speed was fast since the B₂O₃ content was less than a prescribed amount, the transmission factor was 84%, the refractive index was 2.3 and the amorphous nature was 3.4 and showed inferior results.

With Comparative Example 6, since the Zn oxide content and Sn oxide content were low and the B oxide content was high, the deposition speed was 0.04nm/sec (0.4Å/sec) even with radio frequency sputtering and showed significantly inferior results.

With Comparative Example 7, since the Zn oxide content and B oxide content were low and the Sn oxide content was high, the transmission factor was 83%, the refractive index was 2.4 and the amorphous nature was 3.1 and showed inferior results.

### INDUSTRIAL APPLICABILITY

Since the thin film formed by using a sputtering target as described herein forms a part of the structure of the optical information recording medium and does not use ZnS, it yields a significant effect in that diffusion of the sulfur constituent to the recording layer material will not occur, and deterioration of the recording layer can be prevented thereby. Further, when using pure Ag or Ag alloy having high thermal conduction properties at a high reflection ratio as material of adjacent reflective layers, diffusion of the sulfur constituent to such reflective layers will not occur, and a superior effect is yielded in that the cause of the reflective layer being subject to corrosive degradation and causing characteristic degradation can be cleared out.

Further, in addition to the amorphous nature becoming stabilized, the target will be provided with conductivity, and stable RF sputtering deposition will be enabled by making the relative density a high density of 90% or higher. Moreover, there is a significant effect in that the controllability of sputtering can be facilitated, the deposition speed can be increased, and the sputtering efficiency can also be improved. Further still, there is significant effect in that it is possible to reduce the particles (dust) or nodules arising during sputtering upon performing deposition, improve the mass productivity with little variation in quality, and stably manufacture an optical recording medium having an optical disk protective film at low costs.

## Claims

1. A method of manufacturing an optical information recording medium by forming a thin film in a part of an optical information recording medium by the use of a sputtering target formed from a material obtained by adding SiO₂ to an In₂O₃-ZnO-SnO₂ system compound oxide having SnO₂ as its primary component, wherein the sputtering target is formed from oxide composed with the respective element ratios being In/(In + Zn + Sn + Si) = 0.01 to 0.43, Zn/(In + Zn + Sn + Si) = 0.02 to 0.47, Sn/(In + Zn + Sn + Si) = 0.19 to 0.82, Si/(In + Zn + Sn + Si) = 0.04 to 0.50 and (Sn + Si)/(In + Zn + Sn + Si) = 0.45 to 0.90.

2. The method according to claim 1, wherein the relative density of the target is 90% or higher.

3. The method according to claim 1 or 2, wherein the thin film is disposed adjacent to a recording layer or a reflective layer of the optical information recording medium.

4. A thin film of an optical information recording medium formed by the use of a sputtering target formed from a material obtained by adding SiO₂ to an In₂O₃-ZnO-SnO₂ system compound oxide having SnO₂ as its primary component, wherein the sputtering target is formed from oxide composed with the respective element ratios being In/(In + Zn + Sn + Si) = 0.01 to 0.43, Zn/(In + Zn + Sn + Si) = 0.02 to 0.47, Sn/(In + Zn + Sn + Si) = 0.19 to 0.82, Si/(In + Zn + Sn + Si) = 0.04 to 0.50 and (Sn + Si)/(In + Zn + Sn + Si) = 0.45 to 0.90.

5. A thin film according to claim 4, wherein the thin film is disposed adjacent to a recording layer or a reflective layer of the optical information recording medium.

## Patentansprüche

1. Verfahren zur Herstellung eines optischen Informationsaufzeichnungsmediums durch Ausbildung einer Dünnschicht in einem Teil eines optischen Informationsaufzeichnungsmediums durch die Verwendung eines Sputtertargets, das aus einem Material gebildet ist, das durch Zugabe von SiO₂ zu einem In₂O₃-ZnO-SnO₂-System-Verbindungsoxid erhalten wird, das SnO₂ als Hauptkomponente besitzt, wobei das Sputtertarget aus Oxid gebildet ist, das zusammengesetzt ist, wobei die jeweiligen Elementverhältnisse In/(In + Zn + Sn + Si) = 0,01 bis 0,43, Zn/(In + Zn + Sn + Si) = 0,02 bis 0,47, Sn/(In + Zn + Sn + Si) = 0,19 bis 0,82, Si/(In + Zn + Sn + Si) = 0,04 bis 0,50 und (Sn + Si)/(In + Zn + Sn + Si) = 0,45 bis 0,90 betragen.

2. Verfahren nach Anspruch 1, wobei die relative Dichte des Targets 90% oder mehr beträgt.

3. Verfahren nach Anspruch 1 oder 2, wobei die Dünnschicht neben einer Aufzeichnungsschicht oder einer reflektierenden Schicht des optischen Informationsaufzeichnungsmediums angeordnet ist.

4. Dünnschicht eines optischen Informationsaufzeichnungsmediums, das durch die Verwendung eines Sputtertargets ausgebildet ist, das aus einem Material gebildet ist, das durch Zugabe von SiO₂ zu einem In₂O₃-ZnO-SnO₂-System-Verbindungsoxid erhalten wird, das SnO₂ als Hauptkomponente besitzt, wobei das Sputtertarget aus Oxid gebildet ist, das zusammengesetzt ist, wobei die jeweiligen Elementverhältnisse In/(In + Zn + Sn + Si) = 0,01 bis 0,43, Zn/(In + Zn + Sn + Si) = 0,02 bis 0,47, Sn/(In + Zn + Sn + Si) = 0,19 bis 0,82, Si/(In + Zn + Sn + Si) = 0,04 bis 0,50 und (Sn + Si)/(In + Zn + Sn + Si) = 0,45 bis 0,90 betragen.

5. Dünnschicht nach Anspruch 4, wobei die Dünnschicht neben einer Aufzeichnungsschicht oder einer reflektierenden Schicht des optischen Informationsaufzeichnungsmediums angeordnet ist.

## Revendications

1. Un procédé de fabrication d'un moyen d'enregistrement d'informations optiques consistant à former un film mince dans une partie d'un moyen d'enregistrement d'informations optiques à l'aide d'une cible de pulvérisation formée à partir d'un matériau obtenu par l'ajout de SiO₂ à un composé d'oxyde In₂O₃-ZnO-SnO₂ ayant SnO₂ comme composant principal, dans lequel la cible de pulvérisation est formée à partir d'oxyde composé des éléments suivants, selon les rapports indiqués : In/(In + Zn + Sn + Si) = 0,01 à 0,43, Zn/(In + Zn + Sn + Si) = 0,02 à 0,47, Sn/(In + Zn + Sn + Si) = 0,19 à 0,82, Si/(In + Zn + Sn + Si) = 0,04 à 0,50 et (Sn + Si)/(In + Zn + Sn + Si) = 0,45 à 0,90.

2. Le procédé de la revendication 1, dans lequel la densité relative de la cible est de 90 % ou plus.

3. Le procédé de la revendication 1 ou 2, dans lequel le film mince est disposé à côté d'une couche d'enregistrement ou d'une couche réfléchissante du moyen d'enregistrement d'informations optiques.

4. Un film mince d'un moyen d'enregistrement d'informations optiques formé à l'aide d'une cible de pulvérisation formée à partir d'un matériau obtenu par l'ajout de SiO₂ à un composé d'oxyde In₂O₃-ZnO-SnO₂ ayant SnO₂ comme composant principal, dans lequel la cible de pulvérisation est formée à partir d'oxyde composé des éléments suivants, selon les rapports indiqués : In/(In + Zn + Sn + Si) = 0,01 à 0,43, Zn/(In + Zn + Sn + Si) = 0,02 à 0,47, Sn/(In + Zn + Sn + Si) = 0,19 à 0,82, Si/(In + Zn + Sn + Si) = 0,04 à 0,50 et (Sn + Si)/(In + Zn + Sn + Si) = 0,45 à 0,90.

5. Un film mince selon la revendication 4, dans lequel le film mince est disposé à côté d'une couche d'enregistrement ou d'une couche réfléchissante du moyen d'enregistrement d'informations optiques.
